# EUROPÄISCHE PATENTSCHRIFT

(11) **EP 3 451 805 B1**
(45) Veröffentlichungstag und Bekanntmachung des Hinweises auf die Patenterteilung: **04.03.2020**
(21) Anmeldenummer: 18190306.3
(22) Anmeldetag: 22.08.2018
(51) Int. Cl.: H05K 3/28

(54) **VERFAHREN ZUM ÜBERPRÜFEN DER GESCHLOSSENHEIT EINER AUF EINE ELEKTRONISCHE BAUGRUPPE AUFGEBRACHTEN SCHUTZBESCHICHTUNG**
METHOD FOR VERIFYING THE INTEGRITY OF A PROTECTIVE COATING APPLIED ON AN ELECTRONIC ASSEMBLY
PROCÉDÉ DE VÉRIFICATION DE LA HOMOGÉNÉITÉ D'UN REVÊTEMENT DE PROTECTION APPLIQUÉ SUR UN MODULE ÉLECTRONIQUE

(30) Priorität: 23.08.2017 DE 102017119233
(43) Veröffentlichungstag der Anmeldung: 06.03.2019
(73) Patentinhaber: Dr. O.K. WACK CHEMIE GmbH, 85053 Ingolstadt (DE)
(72) Erfinder: Schweigart, Helmut, 85053 Ingolstadt (DE)
(74) Vertreter: Kramer Barske Schmidtchen Patentanwälte PartG mbB

(56) Entgegenhaltungen:
- WO-A2-2009/120951
- CN-A- 101 638 785
- US-A- 5 139 813
- US-A1- 2016 324 011
- US-B1- 6 319 543

## Beschreibung

Die vorliegende Erfindung betrifft ein Verfahren zum Überprüfen der Geschlossenheit einer auf mindestens einen metallischen Bereich einer fertig bestückten Leiterplatte aufgebrachten Beschichtung.

Elektronische Baugruppen, wie beispielsweise Leiterplatten, weisen metallische Bereiche oder Bauteile in Form von beispielsweise elektrischen Leitern, Leiterbahnen oder Kontaktstellen auf. Nach der Montage einer elektronischen Baugruppe wird diese beispielsweise zum Schutz gegen schädliche klimatische Umwelteinflüsse und der damit verbundenen möglichen Korrosion oder auch zur Isolierung der Leiter gegen die Umwelt mit einer bevorzugt organischen und bevorzugt transparenten Beschichtung versehen. Hierzu werden als Beschichtungsmittel beispielsweise Lacke aus Polyurethan, Acrylat, Epoxidharz oder Silikon bzw. Mischungen hieraus verwendet. Hinzu kommen Beschichtungen auf Basis von Perfluorverbindungen oder Parylen. Die Schichtdicken variieren dabei beispielsweise zwischen 1 µm bis über 100 µm.

Um den Schutz gegen die schädlichen klimatischen Umwelteinflüsse zu gewährleisten, muss sichergestellt sein, dass die organische Beschichtung, d.h. der Lack bzw. Schutzstoff, bevorzugt mindestens die metallischen Bereiche, noch bevorzugter den Lötstopplack und die Gehäuse der elektronischen Bauelemente zur Kompensation von dortigen Fehlstellen, die elektrischen Leiter, Leiterbahnen und/oder Kontaktstellen vollständig überdeckt. Es dürfen also keine Fehlstellen in der Beschichtung vorhanden sein.

Fehlstellen können beispielsweise durch Kantenflucht, Verunreinigungen des Beschichtungsmittels und/oder der zu beschichtenden Fläche, Fehler beim Aufbringen des Beschichtungsmittels bzw. der Beschichtung, oder mechanische Einflüsse nach dem Aufbringen des Beschichtungsmittels bzw. der Beschichtung entstehen.

Die derzeit bekannten Prüfmöglichkeiten, ob die Schutzbeschichtung fehlerfrei, d.h. ohne Fehlstellen aufgebracht wurde, umfassen unter anderem eine Inspektion mit Schwarzlicht unter Zugabe eines Fluoreszenzmittels in der Beschichtung, Umweltsimulationsprüfungen und dem sogenannten Coating Reliability (CoRe-) Test nach GfKORR (Gesellschaft für Korrosionsschutz; Leitfaden für die Anwendung und Verarbeitung von Schutzlacken für elektronische Baugruppen). Die bekannten Tests sind teilweise unzuverlässig, zeitintensiv und/oder aufwendig und damit meist kostenintensiv.

Die DE 697 36 946 T2 beschreibt ein Verfahren zum Überprüfen einer auf eine als Leiterplatte ausgebildeten elektronischen Baugruppe aufgebrachten Beschichtung.

WO 2009/120951 A2 offenbart ein automatisiertes System zur Prüfung der Schutzbeschichtung auf bestückte Leiterplatten mittels UV-Licht.

### Zusammenfassung der Erfindung

Es ist eine Aufgabe der vorliegenden Erfindung, ein Verfahren zur Überprüfung der Geschlossenheit einer auf eine metallische Baugruppe, d.h. eine elektronische Baugruppe, aufgebrachten Beschichtung (bzw. Schutzlack oder organische, teilorganische oder anorganische Schutzbeschichtung) anzugeben, welches einfach und kostengünstig durchführbar ist.

Diese Aufgabe wird gelöst mit einem Verfahren nach Anspruch 1. Weiterbildungen sind in den abhängigen Ansprüchen angegeben.

Mit dem hier offenbarten Verfahren werden Fehlstellen in der Beschichtung, d.h. nicht mit einer Beschichtung überdeckte Metallbereiche, über eine Redoxreaktion nachgewiesen.

Das vorliegende Verfahren kommt erfindungsgemäß bei fertig bestückten Leiterplatten (Assemblies), zum Einsatz.

Die elektronische Baugruppe ist eine bestückte Leiterplatte, wie eine Leiterkarte, Platine oder gedruckte Schaltung; Englisch: assembled printed circuit board, oder ein bestücktes 3D-Gebilde sein. Leiterplatten dienen als Träger für elektronische Bauteile oder Bauelemente. Leiterbahnen dienen zur Verbindung der elektronischen Baugruppe mit externen Geräten oder zur Verbindung der Bauteile oder Bauelemente untereinander. Elektronische Bauteile/Bauelemente sind beispielsweise Widerstände, Kondensatoren, aktive Chips, etc.

Leiterplatten oder entsprechende 3D-Gebilde werden aus einem elektrisch isolierenden Material, wie einem Faserverbundbauteil, in Form einer Platte ausgebildet. Auf diese Platte werden anschließend Leiterbahnen entsprechend eines vorher bestimmten Layouts beispielsweise aufgeätzt. Weiter werden einseitige Kontaktierungsbereiche bzw. -flächen, wie Lötflächen, Pads, oder zweiseitige Kontaktierungsbereiche bzw. -flächen als in der Leiterplatte vorgesehene Lötaugen in Form von, die Leiterplatte durchdringenden, Löchern vorgesehen, die zur Verbindung nach extern oder zur Verbindung mit elektronischen Bauelementen oder Bauteilen ausgebildet sind. Die Leiterbahnen können beispielhaft aus Kupfer mit einer Dicke von üblicherweise 35 µm ausgebildet sein. Je nach geforderter Stromstärke können aber auch Leiterbahnen im Millimeterbereich oder kleiner als im µm-Bereich sein.

Nach dem Herstellen der Rohleiterplatte wird diese mit elektronischen Bauteilen bzw. Bauelementen bestückt. Dafür werden freiliegende metallische Bereiche der elektronischen Bauteile bzw. Bauelemente mit den dafür vorgesehenen Kontaktierungsbereichen bzw. -flächen verlötet,beispielsweise mittels Lötzinn, z.B. als Paste oder Preform. Andere Verfahren zum Aufbau und zur Verbindungstechnik sind neben dem Löten das Sintern, Kleben oder Crimpen von elektronischen Bauteilen,wie Dioden, Kondensatoren, Wiederstände, etc., auf die jeweilige Leiter- bzw. Grundplatte, wieFR4-Leiterplatte, DCB, Dickschicht-Leiterplatte, etc.. Auch hier ist eine Anwendung des Tests nach dem beschriebenen Verfahren möglich.

Auf die bestückte elektronische Baugruppe wird anschließend eine Beschichtung aufgebracht, mit der insbesondere die metallischen Bereiche, d.h. die Leiter, Leiterbahnen, Kontaktierungsflächen, Lötaugen und verlöteten Bereiche der Leiterplatten und/oder die Bauteile bzw. die Bauelemente beschichtet werden.

Die in dieser Offenbarung beschriebenen Beschichtungen sind bevorzugt organisch und transparent oder eingefärbt, z.B. rot, blau, schwarz, etc.. Das Material der Beschichtung kann beispielsweise Polyurethan (PUR), Acrylat (AR), Alkyd, Silikon (bzw. Silikon SR), Epoxid (EP), Polyamid (PA), Olefin bzw. Wachs oder deren Mischungen sein. Weiter können beispielsweise sehr dünne Beschichtungen aus Parylen oder auf Basis von Perfluorverbindungen, z.B. Perfluordispersionen, zum Einsatz kommen.

Die jeweilige Baugruppe kann vollständig oder nur lokal beschichtet sein.

Die Schichtdicken variieren dabei beispielsweise bevorzugt von 0,5 µm bis 1000 µm und besonders bevorzugt von 5 µm bis 200 µm, bzw. von 20 µm bis 80 µm, wie beispielsweise 30 oder 50 µm.

Mit dem im Weiteren beschriebenen Verfahren zur Überprüfung der Beschichtung kann auch bei den zuletzt genannten sehr dünnen Beschichtungen auf einen Fluoreszenzzusatz zur Überprüfung der Geschlossenheit der Filmbildung verzichtet werden.

Die Beschichtung wird beispielsweise manuell oder maschinell mittels jedes bekannten Verfahrens aufgetragen. Beispielsweise wird die Beschichtung manuell oder maschinell mittels eines Sprüh- oder Spritzverfahrens aufgetragen. Alternative Verfahren zum Aufbringen der Beschichtung sind beispielsweise tauchen, pinseln, gießen und dispensen.

Die bevorzugt wässrige und bevorzugt klare Silbernitratlösung reagiert dafür in einer Redoxreaktion mit den in Fehlstellen zur Umgebung freiliegenden, d.h. nicht mit einer Beschichtung bzw. Schutzlack überdeckten Metallbereichen. Die Metallbereiche sind bevorzugt aus Zinn, Kupfer, Nickel, bzw. nickelhaltige Verbindungen, wie NiP/Ni, NiB/Ni oder ENIG (Electroless Nickel Immersion Gold), oder anderen unedleren Metallen, wie Ferriten (Fe, Fe/NiZn, Fe/Mn), oder Legierungen aus oder mit diesen Materialien ausgebildet. Das vorliegende Verfahren zur Überprüfung der Geschlossenheit einer auf eine metallische Baugruppe aufgebrachten Beschichtung kann für jedes metallische Teil benutzt werden, das mit Silbernitrat in einer Redoxreaktion reagiert. Diese Metallbereiche bilden bevorzugt die Leiter, Leiterbahnen oder Kontaktstellen einer elektronischen Baugruppe, insbesondere einer Leiterplatte und der Bauelemente, aus.

Die Silbernitratlösung enthält Wasser und bevorzugt mindestens 5 bis 2160 g/L AgNO₃, weiter bevorzugt 6 bis 50 g/L AgNO₃, und noch weiter bevorzugt 7 bis 20 g/L AgNO₃. Besonders bevorzugt ist eine Konzentration der Silbernitratlösung von beispielsweise 12,7 g/L (0,075 mol/L).

Die vorliegende Silbernitratlösung kann zusätzlich ein Tensid, das aus der Gruppe bestehend aus kationischen, anionischen, amphoteren oder nichtionischen Tensiden ausgewählt ist, oder eine Mischung aus mehreren Tensiden umfassen, die mindestens zwei der oben genannten Tenside umfasst. Mögliche kationische Tenside sind quartäre Ammoniumverbindungen, wie quartäre Ammoniumester, beispielsweise quartäre Triethanol-methyl-ammonium- oder quartäre Diethanol-dimethyl-ammonium-Verbindungen. Die quartären Ammoniumverbindungen sind dadurch gekennzeichnet, dass sie bevorzugt keine Komplexe mit Ag-Ionen bilden und bevorzugt keine Gegenionen (Anionen) enthalten, die mit Ag-Ionen schwer lösliche Niederschläge bilden. Solche Anionen sind beispielsweise Halogenid-Ionen, wie unter anderem Chloride oder Bromide. Mögliche anionische Tenside sind Alkylethersulfate, Alkylsulfonate oder Fettalkoholsulfate. Mögliche amphotere Tenside sind Betaine oder Sultaine. Die verwendeten Betaine oder Sultaine sind dadurch gekennzeichnet, dass sie bevorzugt keine Komplexe mit Ag-Ionen bilden. Mögliche nichtionische Tenside sind Alkylpolyglucoside oder Fettalkoholate, wie Fettalkoholethoxylate, Fettalkoholpropoxylate.

Die Tensidkonzentration in der Silbernitratlösung beträgt bevorzugt 1 g/L bis 100 g/L. Besonders bevorzugt zwischen 1 und 50 g/L, wie beispielsweise 2 g/L.

Durch das Tensid in der Silbernitratlösung kann das Verfahren bzw. die Vorrichtung dahingehend verbessert werden, dass Fehlstellen im Lack, deren Durchmesser oder Porenabmessung kleiner als 1 µm ist, detektierbar sind. Durch die Tenside kann auch eine Benetzung von freiliegenden Metallbereichen derart kleiner Fehlstellen in dem Schutzlack sichergestellt werden. Insbesondere soll durch die Tenside (Netzmittel) eine Oberflächenspannung unter die von Kondenswasser gesenkt werden, so dass sichergestellt wird, dass alle metallischen Bereiche, die von Kondenswasser benetzt werden würden, erkannt werden.

Über die Redoxreaktion können innerhalb von bevorzugt 0,5 bis 5 Minuten, besonders bevorzugt 1 bis 4 Minuten, wie beispielsweise bevorzugt 3 Minuten, Einwirkzeit in einem Temperaturbereich von 10 bis 30 °C, bevorzugt bei Raumtemperatur, Fehlstellen durch Kantenflucht der Beschichtung auf Baugruppen bis hin zu mikrostrukturellen Fehlstellen im Lack nachgewiesen werden. Der Test,d.h. die Silbernitrat enthaltende Lösung, kann mittels Tropfflasche oder Sprühflasche lokal, aber auch durch Tauchen,Spülwirkung ist zu vermeiden, auch vollflächig durchgeführt werden.

Die Silbernitratlösung reagiert während der vorbestimmten Zeitdauer t₁, d.h. 0,5 bis 5 min, in einer Redoxreaktion mit offen liegenden metallischen Bereichen, die nicht von dem Schutzlack überzogen bzw. haftend bedeckt sind.

Die entsprechende Reaktionsgleichungen für Kupfer, Entstehung eines Cu(I)- bzw. Cu(II)-Nitrats, lauten:

Cu + AgNO₃ → CuNO₃ + Ag

Cu + 2AgNO₃ → Cu(NO₃)₂ + 2Ag

Die für Nickel, auch aus Ni/NiP,Entstehung eines Ni(II)-Nitrats, lautet:

Ni + 2AgNO₃ → Ni(NO₃)₂ + 2Ag

Die für Zinn, Entstehung eines Sn(II)-Nitrats, lautet:

Sn + 2AgNO₃ → Sn(NO₃)₂ + 2Ag

An den offen liegenden metallischen Bereichen lagern sich in der Reaktion Silberteilchen/Silberpartikel/Silberkristalle an, die dunkelgrau bis schwarz erscheinen. Bei Eintrocknung der Testlösung belegen die entstandenen Ag-Kristalle als Partikel die Oberfläche und führen so zu einer permanenten Anfärbung durch eine Schwarz- bzw. Dunkelfärbung der Fehl- bzw. Defektstelle(n) der Beschichtung.

Zur Beurteilung bzw. Überprüfung, ob die Beschichtung alle oder zumindest die mit der Silbernitratlösung benetzten metallischen Bereiche einer bestückten Leiterplatte (elektrischen Baugruppe) vollständig überdeckt bzw. umschlossen hat, wird beispielsweise die mit der Silbernitratlösung reagierte Baugruppe bevorzugt unter 3-20-facher optischer Vergrößerung ,beispielsweise mit einer Lupe oder eines Mikroskops, auf dunkle, d.h.dunkelgraue, oxidierte, Stellen untersucht.

Weiter kann auch die optische Auswertung, d.h. das Überprüfen, ob eine Reaktion der Silbernitratlösung mit einem metallischen Bereich stattgefunden hat oder nicht, mittels Lupe oder entsprechender elektronischer Vorrichtungen, wie beispielsweise einer optischen Aufhahmeeinrichtung (Kamera) unterstützt oder vollständig durchgeführt werden. Neben einer elektronischen Aufnahme und Vergrößerung des Bildes zur besseren Auswertung durch einen Nutzer können die mit einer elektronischen optischen Aufhahmeeinrichtung (AOI) aufgenommenen Bilder auch mittels einer geeigneten computergesteuerten Auswerteeinrichtung (CPU, Computer), in der ein entsprechender Algorithmus zur Auswertung der elektronischen Bilder, insbesondere ein AOI-System, auf für eine Reaktion charakteristische Bereiche durch eine Dunkelgraufärbung durch eine Oxidation des Kupfers, und gebildeter Silberkristalle gespeichert ist, ausgewertet werden. Hierdurch ist auch eine vollständig automatische Qualitätskontrolle der Leiterplatten bezüglich der aufgebrachten Beschichtung möglich.

Werden keine solchen Stellen, d.h. dunkle Stellen oder Stellen mit Silberkristallen, gefunden, ist davon auszugehen, dass die Beschichtung (Schutzlackierung) erfolgreich war und keine zur Umgebung offen liegenden, also ungeschützten metallischen Bereiche auf der elektronische Baugruppe vorhanden sind. In diesem Fall, wird die elektronische Baugruppe, z.B. die bestückte Leiterplatte mit wässrigen oder organischen polaren Lösungsmitteln, bevorzugt mit Wasser oder Isopropylalkohol (IPA), abgespült und idealerweise vorsichtig mit Druckluft getrocknet, um Rückstände der Silbernitratlösung zu entfernen. Werden hingegen solche Stellen gefunden, ist davon auszugehen, dass die Beschichtung nicht vollständig erfolgreich war und zur Umgebung offen liegende metallische Bereiche, d.h.mit schlechter, nicht durchgängiger Beschichtung, auf der elektronischen Baugruppe, z.B. Leiterplatte, vorhanden sind. In diesem Fall, kann die elektronische Baugruppe beispielsweise als fehlerhaft aussortiert werden.

Die vorliegende Offenbarung gibt somit ein kostengünstiges und einfaches Verfahren zum Überprüfen einer (Schutz-) Beschichtung von elektronischen Bauteilen an.

Die vorliegende Offenbarung umfasst also auch eine Vorrichtung zum Überprüfen einer auf eine elektronische Baugruppe aufgebrachten Beschichtung, die aufweist:
einen Behälter mit Silbernitratlösung,
eine Handhabungsvorrichtung zum Einbringen und Ausbringen einer elektronischen Baugruppe mit einem metallischen Bereich, die mit einer Beschichtung versehen ist.

Bevorzugt weist eine solche Vorrichtung weiter
eine Bilderzeugungseinrichtung zur Erzeugung eines Bildes der Beschichtung, und/oder eine Bildauswerteinrichtung zur Auswertung des Bildes der Beschichtung, und/oder eine Anzeigeeinrichtung zum Anzeigen eines Ergebnisses der Bildauswertung, und/oder eine Steuereinrichtung zur Steuerung des Betriebs der Handhabungsvorrichtung und/oder der Einrichtungen auf.

Weitere Weiterbildungen, Vorteile und Zweckmäßigkeiten der vorliegenden Offenbarungen ergeben sich aus der Beschreibung der Ausführungsbeispiele anhand der beigefügten Figuren.

Kurze Beschreibung der Zeichnungen
Fig. 1 zeigt eine Aufsicht auf eine elektronische Baugruppe, hier Leiterplatte.
Fig. 2 zeigt eine Seitenansicht auf die in ein Tauchbecken eingetauchte elektronische Baugruppe.
Fig. 3 zeigt eine fotografische Aufsicht auf die elektronische Baugruppe nach dem Entnehmen aus dem Tauchbecken und Abwarten einer Reaktionszeit.
Fig. 4 zeigt einen vergrößerten Ausschnitt aus Fig. 3.
Fig. 5 zeigt eine schematische Aufsicht auf eine elektronische Baugruppe nach dem Entnehmen aus dem Tauchbecken und Abwarten einer Reaktionszeit.
Fig. 6 zeigt einen vergrößerten Ausschnitt aus Fig. 5.
Fig. 7 zeigt eine Querschnittsansicht einer elektronischen Baugruppe nach dem Entnehmen aus dem Tauchbecken und Abwarten einer Reaktionszeit.

### Ausführungsformen der Erfindung

In einer ersten Ausführungsform ist die elektronische Baugruppe 1 eine Leiterplatte, wie eineLeiterkarte, Platine oder gedruckte Schaltung; Englisch: printed circuit board. Leiterplatten dienen als Träger für elektronische Bauteile 2 oder Bauelemente. Leiterbahnen 3 dienen zur Verbindung der elektronischen Baugruppe 1 mit externen Geräten oder zur Verbindung der Bauteile 2 oder Bauelemente untereinander. Elektronische Bauteile/Bauelemente 2 sind beispielsweise Widerstände, SMD, Computerchips, etc.

Leiterplatten werden normalerweise aus einem elektrisch isolierenden Material, wie einemFaserverbundbauteil, in Form einer Platte ausgebildet. Auf diese Platte werden anschließend Leiterbahnen 3 entsprechend eines vorher bestimmten Layouts beispielsweise aufgeätzt. Weiter werden einseitige Kontaktierungsbereiche 4.1/4.2 bzw. -flächen, wieLötflächen, Pads, oder zweiseitige Kontaktierungsbereiche 4.1/4.2 bzw. -flächen als in der Leiterplatte vorgesehene Lötaugen in Form von, die Leiterplatte durchdringenden, Löchern vorgesehen, die zur Verbindung nach extern oder zur Verbindung mit elektronischen Bauelementen 2 oder Bauteilen ausgebildet sind. Die Leiterbahnen 3 sind in dieser Ausführungsform beispielhaft aus Kupfer mit einer Dicke von üblicherweise 35 µm ausgebildet. Die Kontaktierungsflächen und Lötaugen sind in dieser Ausführungsform beispielhaft der Einfachheit halber ebenfalls aus Kupfer hergestellt. Die so hergestellte Rohleiterplatte wird auch Bare-Board genannt.

Nach dem Herstellen der Rohleiterplatte wird diese mit elektronischen Bauteilen 2 bzw. Bauelementen bestückt. Dafür werden freiliegende metallische Bereiche der elektronischen Bauteile 2 bzw. Bauelemente mit den dafür vorgesehenen Kontaktierungsbereichen 4.1/4.2 bzw. - flächen verlötet,beispielsweise mittels Lötzinn, z.B. als Paste oder Preform. In der vorliegenden Ausführungsform wurde eine Zinn-Silber-Kupfer-Paste reflow-gelötet.

Die (Schutz-) Beschichtung 5 dient zur elektrischen Isolierung der metallischen (leitenden) Bereiche 2, 3, 4.1 von der Umgebung zur Vermeidung von beispielsweise Kriechströmen oder Spannungsüberschlägen, aber auch zur Isolierung gegenüber Umwelteinflüssen, wie Nässe, Flussmittel, Gase, Handschweiß, Öle, Laugen, Säuren, zum Schutz der metallischen Bereiche 2, 3, 4.1 vor Korrosion, elektrochemischer Migration etc. zur Gewährleistung der Funktion der elektrischen Baugruppe 1. Auf die bestückte Rohleiterplatte 1 wird anschließend die (Schutz-) Beschichtung 5 aufgebracht, mit der insbesondere die metallischen (leitenden) Bereiche 2, 3, 4.1 hier aus Kupfer, d.h. die Leiter 3, Leiterbahnen, Kontaktierungsflächen, Lötaugen und verlöteten Bereiche der Leiterplatten 1 und/oder Bauteile bzw. Bauelemente 2 beschichtet werden sollen.

Die Beschichtung 5 kann ganz oder teilweise auf die Leiterplatte 1 bzw. auf die an der Leiterplatte befestigten bzw. mit der Leiterplatte verbundenen Bauteile bzw. Bauelemente 2 aufgebracht werden. Beispielsweise können Kontaktierungsbereiche 4.2, die später zur elektrischen Verbindung der Leiterplatte 1 nach außen (extern) dienen, von der Beschichtung 5 ausgenommen werden.

Das Material der Beschichtung 5 besteht aus Acrylaten (AY). Insbesondere wurde ein Peters SL1307 Schutzlack verwendet.

Die Beschichtung 5 wurde maschinell mittels eines Sprühverfahrens aufgetragen. Alternative Verfahren zum Aufbringen der Beschichtung 5 sind beispielsweise tauchen, pinseln, gießen, spritzen oder dispensen.

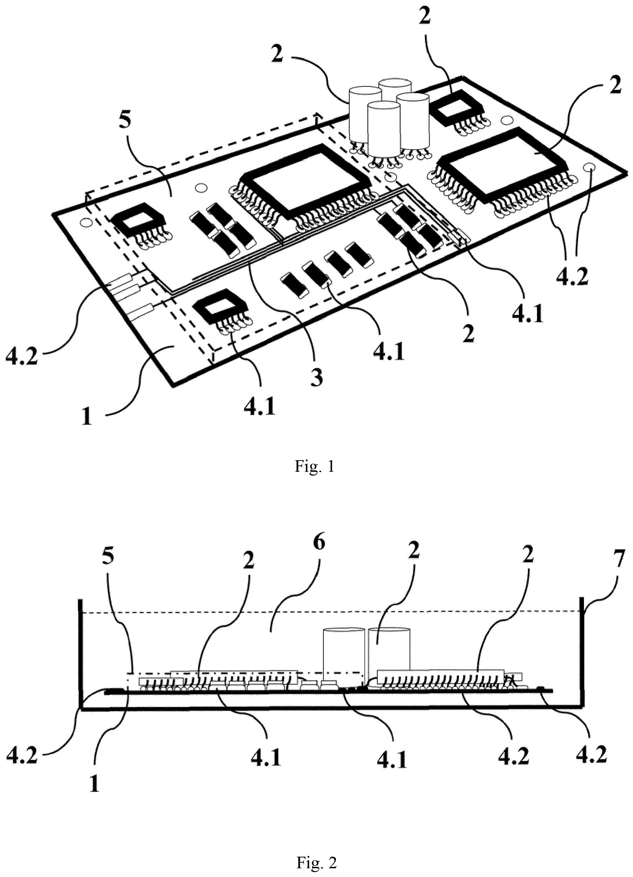

Die so fertig hergestellte bestückte Leiterplatte 1 wird auch als Assembly bezeichnet und ist beispielhaft in Fig. 1 gezeigt. Bevorzugt wird die Erfindung auf solche fertig hergestellten, d.h. bestückten und mit einer Schutzbeschichtung 5 versehenen, Leiterplatten 1 angewendet.

Wie aus Fig. 1 ersichtlich ist, sind auf der Leiterplatte 1 beispielhaft verschiedene elektronische Bauelemente bzw. Bauteile 2, verschiedene Leiterbahnen 3 und verschiedene Kontaktierungsbereiche bzw. -flächen 4.1/4.2 vorhanden. Zudem ist die transparente Beschichtung 5 in Form eines Schutzlackes, wobei die Leiterplatte 1 vollständig oder teilweise beschichtet ist, mittels eines Sprühverfahrens über die gesamte Leiterplatte 1 aufgebracht.

Zur elektrischen Isolation und zur Vermeidung von Korrosion muss vor einer Auslieferung der Leiterplatte 1 als Qualitätssicherung sichergestellt sein, dass bevorzugt alle metallischen Bereiche 2, 3, 4.1, ausgenommen derjenigen Kontaktierungsbereiche 4.2 zur späteren Kontaktierung nach extern, der fertig hergestellten Leiterplatte 1, d.h. alle Leiterbahnen 3, Kontaktierungsbereiche bzw. -flächen 4.1 und elektronischen Bauelemente bzw. Bauteile 2 und Verbindungsbereiche (Verlötungsbereiche) derselben mit metallischen Oberflächen gegenüber der Umwelt durch den Schutzlack 5 isoliert sind, d.h., dass der Schutzlack 5 die metallischen Bereiche 2, 3, 4.1 vollständig von der Umwelt trennt und eine vollständige und durchgehende Schutzschicht bzw. Beschichtung 5 bzw. einen Schutzmantel bildet.

Zur Überprüfung der Geschlossenheit der Beschichtung 5, zumindest bereichsweise, wird in einem nächsten Schritt eine wässrige und klare Silbernitratlösung 6 mit 12,7 g/L Silbernitratkonzentration, deren mögliche Zusammensetzung weiter unten näher angegeben ist, in einem dafür vorgesehenen Becken 7 bereitgestellt. Das Becken 7 und die Menge der in dem Becken aufgenommenen Silbernitratlösung 6 sind so bemessen, dass die Leiterplatte 1 vollständig in das mit der Silbernitratlösung 6 befüllte Becken 7 eingetaucht werden kann. Alternativ kann, falls beispielsweise auf einer Seite der Leiterplatte 1 Kontaktierungsbereiche 4.2 vorhanden sind, die aufgrund einer später geforderten Kontaktierung derselben gar nicht erst mit dem Schutzlack überzogen wurden und somit keiner Überprüfung bedürfen bzw. bei denen die Überprüfung zu einer unerwünschten Oxidation der Kontaktierungsbereiche 4.2 führen könnte, das Becken 7 und die Menge an Silbernitratlösung 6 so bemessen sein, dass die Leiterplatte 1 nur bis zu einer vorbestimmten Tiefe, die beispielsweise ein Nichteintauchen der Kontaktstellen sicherstellt, eintauchen kann.

In einem nächsten Schritt wird, wie es in Fig. 2 gezeigt ist, die Leiterplatte 1 in die Silbernitratlösung 6 eingetaucht. Hierbei muss sichergestellt werden, dass sich beim Eintauchen der Leiterplatte 1 unter erhabenen elektronischen Bauteilen 2 keine Luftblasen halten können, die eine vollständige Benetzung der Leiterplatte 1 verhindern. Gegebenenfalls sollte die Baugruppe 1 im eingetauchten Zustand zum Verhindern des Anhaftens/Vorhandenseins solcher Luftblasen zusätzlich gedreht werden, sodass die Luftblasen nach oben steigen können.

Die Leiterplatte 1 muss hierauf für eine vorbestimmte Zeitdauer t₁ von vorzugsweise 3 Minuten Reaktionszeit im eingetauchten Zustand gehalten werden. Anschließend wurde die Leiterplatte 1 unter Abtropfen der Silbernitratlösung 6 wieder aus dem Becken 7 herausgenommen.

Durch das Eintauchen der Leiterplatte 1 in die Silbernitratlösung 6 wird also erreicht, dass die Oberfläche der Leiterplatte 1 mit der Silbernitratlösung 6 benetzt wird. Für die Überprüfung, ob die metallischen Bereiche 2, 3, 4.1 durchgehend, d.h. dicht, mit der Beschichtung 5 überzogen sind, müssen die metallischen Bereiche 2, 3, 4.1 bzw. der die metallischen Bereiche überdeckende bzw. umgebende Schutzlack mit der Silbernitratlösung 6 benetzt werden. Mit anderen Worten, die später beschriebene Reaktion der Silbernitratlösung 6 mit möglicherweise vorhandenen freiliegenden metallischen Bereichen 2, 3, 4.1 in Fehlstellen in der Beschichtung 5 kann nur dann stattfinden, wenn diese freiliegenden metallischen Bereiche 2, 3, 4.1 von der Silbernitratlösung 6 benetzt werden. Der Silbernitratlösung 6 ist dafür bevorzugt ein Netzmittel, d.h. ein Tensid oder eine Mischung verschiedener Tenside, zugesetzt, mit dem sichergestellt wird, dass auch kleine und kleinste Fehlstellen in dem Schutzlack (Beschichtung 5 5) von der Silbernitratlösung 6 benetzt werden.

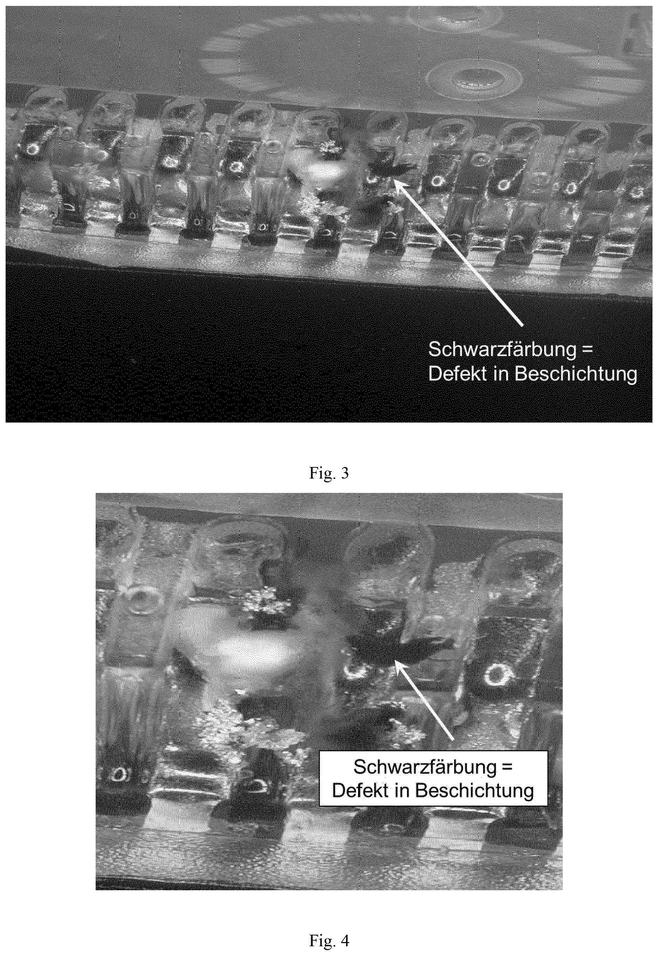

Wie aus den Fig. 3 und 4 ersichtlich ist, reagiert die Silbernitratlösung 6 während der vorbestimmten Zeitdauer t₁ von 3 Minuten in einer Redoxreaktion mit offen liegenden metallischen Bereichen 2, 3, 4.1/4.2, hier Lötzinn; kupferhaltige Legierung, die nicht von dem Schutzlack 5 überzogen bzw. bedeckt sind. Die entsprechende Reaktionsgleichungen für Kupfer, Entstehung eines Cu(I)- bzw. Cu(II)-Nitrats, lauten:

Cu + AgNO₃ → CuNO₃ + Ag

Cu + 2AgNO₃ → Cu(NO₃)₂ + 2Ag

Die für Nickel, auch aus Ni/NiP, Entstehung eines Ni(II)-Nitrats, lautet:

Ni + 2AgNO₃ → Ni(NO₃)₂ + 2Ag

Die für Zinn, Entstehung eines Sn(II)-Nitrats, lautet:

Sn + 2AgNO₃ → Sn(NO₃)₂ + 2Ag

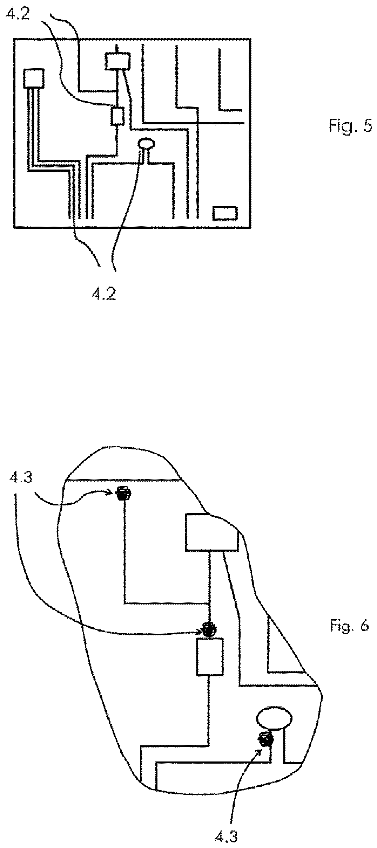

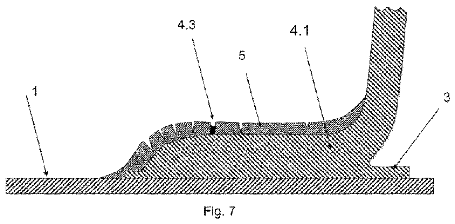

Die offen liegenden metallischen (Kupfer-, Nickel- oder Zinn-) Bereiche 2, 3, 4.1/4.2 erscheinen mit der Abscheidung des Silbers nach der Reaktion dunkelgrau bis schwarz (Fig. 3 bis 7). Bei längerer Reaktionszeit wachsen zudem auf der Oberfläche des Kupfers Silberkristalle.

Zur Beurteilung bzw. Überprüfung, ob der Schutzlack 5 alle oder zumindest die mit der Silbernitratlösung 6 benetzten metallischen Bereiche 2, 3, 4.1 mit guter, durchgehender Beschichtung5 der Leiterplatte 1 vollständig überdeckt bzw. umschlossen hat, wurde die aus dem Becken 7 herausgenommene Leiterplatte 1, vorzugsweise unter 20-facher optischer Vergrößerung, beispielsweise mit einem Mikroskop, auf dunkle, insbesondere dunkelgraue, Stellen 4.3 untersucht. Bei längerer Reaktionszeit von mindestens 5 Minuten kann zusätzlich nach Stellen mit Silberkristallen gesucht werden.

In diesem Fall wurde die Leiterplatte 1 mit Wasser abgespült und vorsichtig mit Druckluft getrocknet, um Rückstände der Silbernitratlösung 6 zu entfernen. In diesem Fall wurden dunkelgraue bis schwarze Stellen gefunden, so dass die Leiterplatte 1 als fehlerhaft aussortiert wurde.

Die vorliegende Offenbarung gibt somit ein kostengünstiges und einfaches Verfahren zum Überprüfen einer (Schutz-) Beschichtung 5 von elektronischen Baugruppen 1 an. Im Weiteren werden nicht abschließend weitere mögliche Ausführungsformen der vorliegenden Offenbarung angegeben, wobei gleiche bzw. ähnliche Bauteile mit gleichen Bezugszeichen bezeichnet werden und auf eine detaillierte Beschreibung gleicher Bauteile und/oder Verfahrensschritte verzichtet wird. Es werden also insbesondere die Unterschiede zu der ersten Ausführungsform beschrieben.

Statt dem Vorsehen der Silbernitratlösung 6 in dem Behälter 7 kann die Silbernitratlösung 6, bevorzugt mit 12,7 g/L Silbernitratkonzentration, auch in einem beispielsweise mobilen Behälter aufbewahrt werden. Mit diesem Behälter 7 kann die Silbernitratlösung 6 auf die Leiterplatte 1 aufgebracht werden. Statt dem Eintauchen wird die Leiterplatte 1 über eine Auffangschale gehalten und mittels der Sprühflasche mit der Silbernitratlösung 6 besprüht, sodass eine vollständige Benetzung der Leiterplatte 1 mit der Silbernitratlösung 6 erreicht wird. Alternativ kann die Silbernitratlösung 6 mittels einer Tropfflasche auf die Leiterplatte 1 oder bestimmte Bereiche von ihr aufgetropft werden, wobei auch hier eine vollständige Benetzung der Leiterplatte 1 oder bestimmter Bereiche mit der Silbernitratlösung 6 erreicht wird. Nach dem Ablauf der vorbestimmten Reaktionszeit t₁, von 3 Minuten, wird auch in diesen Ausführungsformen zur Überprüfung der Beschichtung 5 eine optische Kontrolle auf eine Verfärbung bzw. Ausfällung/Anlagerung von Silberkristallen durchgeführt.

Sowohl das in der ersten Ausführungsform beschriebene Eintauchen und optionale Verschwenken der Leiterplatte 1 in dem Behälter 7 als auch das bezüglich der zweiten Ausführungsform beschriebene Halten der Leiterplatte 1 und Aufbringen der Silbernitratlösung 6 mittels einer Flasche kann nach Bedarf ganz oder teilweise robotergesteuert durchgeführt werden.

Die Überprüfung von dunkelgrauen bis schwarzen Stellen 4.3 wurde wie oben beschrieben untersucht.

Statt dem in der ersten Ausführungsform beschriebenen Eintauchen der Leiterplatte 1 und Abwarten der vorbestimmten Zeitdauer vor dem Herausnehmen der Leiterplatte 1 kann die Leiterplatte 1 nach dem Eintauchen und vollständigen Benetzen oder lokalen Betropfen der zu untersuchenden Stelle auch direkt wieder herausgenommen werden, wenn die Silbernitratlösung 6 derart ausgebildet ist, dass sie zumindest über die vorbestimmte Zeitdauer, d.h. die notwendige Reaktionszeit, an der Leiterplatte 1 bzw. den metallischen Bereichen 2, 3, 4.1/4.2 anhaftet.

Die Testflüssigkeit weist bevorzugt folgende Bestandteile auf:
1. Silbernitrat gelöst in Wasser mit einer Silbernitratkonzentration in einem Konzentrationsbereich von 5 bis 2160 g/L.
2. Netzmittel, welches aus einem Tensid, wie einem kationischen, anionischen, amphoteren oder nichtionischen Tensid, oder aus einem Gemisch mehrerer Tenside, wie aus einem kationischen und/oder anionischen und/oder amphoteren Tensid und/oder nichtionischen Tensid, besteht.

Insbesondere durch das Vorhandensein eines Netzmittels, wie einemTensid oder Tensidgemisch, kann eine Benetzung auch kleinerer Fehlstellen sichergestellt werden.

Die hier verwendeten Begriffe "ungefähr", "etwa", "circa", "im Wesentlichen" oder "im Allgemeinen", die in Zusammenhang mit einem messbaren Wert wie beispielsweise einem Parameter, einer Menge, einer Form, einer zeitlichen Dauer oder dergleichen verwendet werden, schließen Abweichungen oder Schwankungen von ± 10% oder weniger, vorzugsweise ± 5% oder weniger, weiter vorzugsweise ± 1% oder weniger und weiter vorzugsweise ± 0,1% des jeweiligen Wertes oder von dem jeweiligen Wert mit ein, sofern diese Abweichungen bei der Umsetzung der offenbarten Erfindung in die Praxis noch technisch sinnvoll sind. Es wird ausdrücklich darauf hingewiesen, dass der Wert, auf den sich der Begriff "ungefähr" bezieht, als solcher ausdrücklich und im Besonderen offenbart ist. Die Angabe von Bereichen durch Anfangs- und Endwerte umfasst all diejenigen Werte und Bruchteile dieser Werte, die von dem jeweiligen Bereich eingeschlossen sind, wie auch dessen Anfangs- und Endwerte.

Die in der vorliegenden Offenbarung enthaltenen Angaben zu Zusammensetzungen und Konzentrationen beziehen sich auf Raumtemperatur (20°C) und Normaldruck (1013 mbar). Die beschriebenen Anordnungen und Verfahren werden bevorzugt ebenfalls bei Raumtemperatur und Normaldruck durchgeführt.

## Patentansprüche

1. Verfahren zum Überprüfen der Geschlossenheit einer auf mindestens einen metallischen Bereich (2, 3, 4.1/4.2) einer fertig bestückten Leiterplatte (1) aufgebrachten Beschichtung (5) mit folgenden Schritten:
Benetzen der auf den metallischen Bereich (2, 3, 4.1/4.2) aufgebrachten Beschichtung (5) mit einer Silbernitratlösung (6) derart, dass auch in der Beschichtung (5) vorhandene Fehlstellen, die zum Freiliegen der unter der Beschichtung (5) vorhandenen metallischen Bereiche (2, 3, 4.1/4.2) führen, mit der Silbernitratlösung (6) benetzt sind,
Abwarten einer Reaktionszeit (t₁),
Überprüfen der Beschichtung (5) auf durch eine Reaktion der Silbernitratlösung (6) mit der metallischen Oberfläche des metallischen Bereiches (2, 3, 4.1/4.2) entstehende Reaktionsprodukte, und
Feststellen der Beschichtung (5) als nichtgeschlossen bei Vorhandensein von Reaktionsprodukten.

2. Verfahren nach Anspruch 1, bei dem
der mindestens eine metallische Bereich (2, 3, 4.1/4.2) ein elektronisches Bauelement (2) und/oder eine Leiterbahn und/oder ein Leiter (3) und/oder ein Kontaktierungsbereich (4.1/4.2) der fertig bestückten Leiterplatte (1) ist.

3. Verfahren nach Anspruch 1 oder 2, bei dem
der mindestens eine metallische Bereich (2, 3, 4.1/4.2) dazu ausgebildet ist, im Betrieb der Leiterplatte elektrische Ladungsträger zu transportieren.

4. Verfahren nach einem der Ansprüche 1 bis 3, bei dem
der mindestens eine metallische Bereich (2, 3, 4.1/4.2) aus Zinn, Kupfer, Nickel und/oder nickelhaltigen Verbindungen wie NiP/Ni, NiB/Ni oder anderen unedleren Metallen wie Ferriten aus Fe, Fe/NiZn, Fe/Mn oder Legierungen mit diesen Materialien oder anderen unedleren Metallen, die mit Silbernitrat in einer Redoxreaktion reagieren, gebildet ist.

5. Verfahren nach einem der Ansprüche 1 bis 4, bei dem
die Silbernitratlösung (6) ein Netzmittel, das ausgewählt ist aus einem kationischen, anionischen oder amphoteren Tensid oder einem Gemisch aus diesen Tensiden, enthält.

6. Verfahren nach einem der Ansprüche 1 bis 5, bei dem
die Silbernitratlösung (6) Wasser und mindestens 5 bis 2160 g/L AgNO₃ enthält.

7. Verfahren nach einem der Ansprüche 1 bis 6, bei dem
die Reaktionszeit (t₁) zwischen 0,5 und 5 Minuten beträgt.

8. Verfahren nach einem der Ansprüche 1 bis 7, bei dem
der Schritt des Überprüfens mittels eines optischen Vergrößerungsmittels erfolgt.

9. Verfahren nach einem der Ansprüche 1 bis 8, bei dem
die Beschichtung (5) aus organischem Material ist und zum Schutz gegen Korrosion und Umwelteinflüsse vorgesehen ist, und/oder
die Beschichtung (5) eine Parylenbeschichtung oder eine Beschichtung auf Basis von Perfluorverbindungen ist, und/oder
die Beschichtung (5) als Lack aus Polyurethan, Acrylat, Epoxidharz oder Silikon oder Mischungen hieraus gebildet ist.

10. Verfahren nach einem der Ansprüche 5 bis 9, bei dem
die Silbernitratlösung (6) das Netzmittel in einer Konzentration von 1 g/L bis 100 g/L enthält, um eine Benetzung von Fehlstellen kleiner als 1 µm in der Beschichtung (5) mit der Silbernitratlösung (6) zu erreichen.

11. Verfahren nach einem der Ansprüche 1 bis 10, bei dem
bei Vorhandensein von nicht mit der Beschichtung (5) bedeckten metallischen Bereichen (2, 3, 4.1/4.2) die Reaktionsprodukte dunkel verfärbte Bereiche (4.3) des mindestens einen metallischen Bereichs (2, 3, 4.1/4.2) aus Silberkristallanlagerungen bilden.

12. Verwendung einer Silbernitratlösung (6), die ein Netzmittel, das ausgewählt ist aus einem kationischen, anionischen oder amphoteren Tensid oder einem Gemisch aus diesen Tensiden, enthält, zum Überprüfen der Geschlossenheit einer auf mindestens einen metallischen Bereich (2,3,4.1/4.2) einer fertig bestückten Leiterplatte (1) aufgebrachten Beschichtung (5) mit einem Verfahren nach einem der Ansprüche 1 bis 11.

## Claims

1. Method for checking the integrity of a coating (5) applied to at least one metallic region (2, 3, 4.1/4.2) of a completely equipped printed circuit board (1), comprising the following steps:
wetting the coating (5) applied onto the metallic region (2, 3, 4.1/4.2) with a silver nitrate solution (6), so that defects present in the coating (5), which cause the exposure of metal regions (2, 3, 4.1/4.2) present under the coating (5), are also wetted with the silver nitrate solution (6),
waiting for a reaction time (ti),
checking the coating (5) for reaction products generated by a reaction of the silver nitrate solution (6) with the metallic surface of the metallic region (2, 3, 4.1 / 4.2), and
determining that the coating (5) is not intact if reaction products are present.

2. Method according to claim 1, wherein
the at least one metallic region (2, 3,4.1 /4.2) is an electronic component (2) and / or a conductive trace and / or a conductor (3) and / or a contacting region (4.1 / 4.2) of the completely equipped printed circuit board (1).

3. Method according to claim 1 or 2, wherein
the at least one metallic region (2, 3,4.1 / 4.2) is configured to transport electric charge carriers during the operation of the printed circuit board.

4. Method according to any one of claims 1 to 3, wherein
the at least one metallic region (2, 3,4.1/4.2) is formed from tin, copper, nickel and / or compounds containing nickel such as NiP / Ni, NiB / Ni or other non-precious metals such as ferrites composed of Fe, Fe / NiZn, Fe / Mn or alloys with these materials or other non-precious metals, which react with silver nitrate in a redox reaction.

5. Method according to any one of claims 1 to 4, wherein
the silver nitrate solution (6) contains a wetting agent, which is selected from a cationic, anionic or amphoteric surfactant or a mixture of these surfactants.

6. Method according to any one of claims 1 to 5, wherein
the silver nitrate solution (6) contains water and at least 5 to 2160 g / L of AgNO₃.

7. Method according to any one of claims 1 to 6, wherein
the reaction time (t₁) is between 0.5 and 5 minutes.

8. Method according to any one of claims 1 to 7, wherein
the checking step is carried out using an optical magnification means.

9. Method according to any one of claims 1 to 8, wherein
the coating (5) is made of organic material and is provided as a protection against corrosion and environmental influences, and / or
the coating (5) is a parylene coating or a coating based on perfluoro compounds, and / or
the coating (5) is formed as a varnish composed of polyurethane, acrylate, epoxy resin or silicone or mixtures thereof.

10. Method according to any one of claims 5 to 9, wherein
the silver nitrate solution (6) contains the wetting agent in a concentration of 1 g /L to 100 g / L, to obtain a wetting of defects of less than 1 µm in the coating (5) with the silver nitrate solution (6).

11. Method according to any one of claims 1 to 10, wherein
in the presence of metallic regions (2, 3, 4.1 / 4.2) not covered with the coating (5), the reaction products form regions (4.3) of dark coloration of the at least one metallic region (2, 3, 4.1 /4.2) composed of accumulations of silver crystals.

12. Use of a silver nitrate solution (6), which contains a wetting agent, which is selected from a cationic, anionic or amphoteric surfactant or a mixture of these surfactants, to check the integrity of a coating (5) applied to at least one metallic region (2, 3, 4.1 /4.2) of a completely equipped printed circuit board (1) by a method according to any one of claims 1 to 11.

## Revendications

1. Procédé de contrôle de l'intégrité d'un revêtement (5) appliqué sur au moins une zone métallique (2, 3, 4.1/4.2) d'une carte de circuits imprimés (1) complètement équipée, avec les étapes suivantes :
mouiller le revêtement (5) appliqué sur la zone métallique (2, 3, 4.1/4.2) avec une solution de nitrate d'argent (6), de telle sorte que des défauts présents dans le revêtement (5), qui entraînent la mise à découvert des zones métalliques (2, 3, 4.1/4.2) présentes sous le revêtement (5), sont également mouillés avec la solution de nitrate d'argent (6),
attendre un temps de réaction (ti),
contrôler le revêtement (5) en vue d'y détecter des produits de réaction engendrés par une réaction de la solution de nitrate d'argent (6) avec la surface métallique de la zone métallique (2, 3, 4.1/4.2), et
en présence de produits de réaction, déterminer que le revêtement (5) n'est pas intègre.

2. Procédé selon la revendication 1, selon lequel
l'au moins une zone métallique (2, 3, 4.1/4.2) est un composant électronique (2) et/ou un tracé conducteur et/ou un conducteur (3) et/ou une zone de mise en contact (4.1/4.2) de la carte de circuits imprimés (1) complètement équipée.

3. Procédé selon la revendication 1 ou 2, selon lequel
l'au moins une zone métallique (2, 3, 4.1/4.2) est conçue pour transporter des porteurs de charge électriques lors du fonctionnement de la carte de circuits imprimés.

4. Procédé selon l'une quelconque des revendications 1 à 3, selon lequel
l'au moins une zone métallique (2, 3, 4.1/4.2) est formée d'étain, de cuivre, de nickel et/ou de composés contenant du nickel tels que NiP/Ni, NiB/Ni ou d'autres métaux communs tels que des ferrites composées de Fe, Fe/NiZn, Fe/Mn ou alliages avec ces matériaux ou d'autres métaux communs, qui réagissent avec du nitrate d'argent dans une réaction redox.

5. Procédé selon l'une quelconque des revendications 1 à 4, selon lequel
la solution de nitrate d'argent (6) contient un agent mouillant, qui est choisi parmi un tensio-actif cationique, anionique ou amphotère ou un mélange de ces tensio-actifs.

6. Procédé selon l'une quelconque des revendications 1 à 5, selon lequel
la solution de nitrate d'argent (6) contient de l'eau et au moins 5 à 2160 g/L d'AgNO₃.

7. Procédé selon l'une quelconque des revendications 1 à 6, selon lequel
le temps de réaction (t₁) est compris entre 0,5 et 5 minutes.

8. Procédé selon l'une quelconque des revendications 1 à 7, selon lequel
l'étape du contrôle s'effectue à l'aide d'un moyen de grossissement optique.

9. Procédé selon l'une quelconque des revendications 1 à 8, selon lequel
le revêtement (5) est fait de matériau organique et est destiné à assurer une protection contre la corrosion et des influences environnementales, et/ou
le revêtement (5) est un revêtement de parylène ou un revêtement à base de composés perfluoro, et/ou
le revêtement (5) est formé en tant que vernis composé de polyuréthane, d'acrylate, de résine époxyde ou de silicone ou de mélanges de ceux-ci.

10. Procédé selon l'une quelconque des revendications 5 à 9, selon lequel
la solution de nitrate d'argent (6) contient l'agent mouillant dans une concentration de 1 g/L à 100 g/L, afin d'obtenir un mouillage de défauts inférieur à 1 µm dans le revêtement (5) avec la solution de nitrate d'argent (6).

11. Procédé selon l'une quelconque des revendications 1 à 10, selon lequel
en présence de zones métalliques (2, 3, 4.1/4.2) non recouvertes avec le revêtement (5), les produits de réaction forment des zones (4.3) de coloration sombre de l'au moins une zone métallique (2, 3, 4.1/4.2) composée d'accumulations de cristal d'argent.

12. Utilisation d'une solution de nitrate d'argent (6), qui contient un agent mouillant, qui est choisi parmi un tensioactif cationique, anionique ou amphotère ou un mélange de ces tensioactifs, pour contrôler l'intégrité d'un revêtement (5) appliqué sur au moins une zone métallique (2, 3, 4.1/4.2) d'une carte de circuits imprimés (1) complètement équipée avec un procédé selon l'une quelconque des revendications 1 à 11.
